# EUROPEAN PATENT APPLICATION

(11) **EP 3 778 984 A1**
(43) Date of publication of application: **17.02.2021**
(21) Application number: 18911737.7
(22) Date of filing: 15.11.2018
(51) Int. Cl.: C23C 14/34, C22F 1/00, C22F 1/06

(54) **SPUTTERING TARGET MEMBER AND METHOD FOR PRODUCING SAME**

(30) Priority: 26.03.2018 JP 2018059072
(71) Applicant: JX Nippon Mining & Metals Corporation, Tokyo 100-8164 (JP)
(72) Inventor: KOIDO,Yoshimasa, Kitaibaraki-shi, Ibaraki 319-1535 (JP)
(74) Representative: Mewburn Ellis LLP
(86) International application number: PCT/JP2018/042324
(87) International publication number: WO 2019/187311

(57) **Abstract**

Provided is a sputtering target member that can efficiently decrease generation of particles during deposition. The sputtering target member is formed of magnesium having a purity of 99.9% by mass or more, and has an average crystal grain size of magnesium of 42 µm or less.

## Description

### FIELD OF THE INVENTION

The present invention relates to a sputtering target member and a method for manufacturing the same.

### BACKGROUND OF THE INVENTION

Storage elements of magnetic random access memories (MRAMs) are those for large capacity, which are alternative to DRAMs widely used at present, and they are being widely researched and developed as high-speed nonvolatile memories. A tunnel magnetic resistive element (TMR element), which is a central part of the MRAM, has a tunnel structure sandwiching both sides of a tunnel barrier made of an oxide (hereinafter, also referred to as a "barrier layer") by a first and second perpendicular magnetic magnetized electrode layers. An MgO layer is used as the barrier layer. Therefore, there is a need for a sputtering target made of magnesium (Mg) to form the MgO layer.

For example, Patent Literature 1 describes an Mg sputtering target for forming a MgO thin film, wherein inclusions present in a Mg material have a maximum diameter of 5 mm or less.

Further, Patent Literature 2 describes a reactive sputtering target, wherein a surface-modified layer formed by extrusion of a magnesium billet having a purity of 99.9% by weight or more and containing one or more of magnesium oxide, magnesium carbonate, and magnesium hydrate has a controlled thickness of 5 nm or less.

### CITATION LIST

### Patent Literatures

[Patent Literature 1] Japanese Patent Application Publication No. 2002-348663 A
[Patent Literature 2] Japanese Patent Application Publication No. 2001-73126 A

### SUMMARY OF THE INVENTION

An object of the present invention is to provide a sputtering target member that efficiently decreases generation of particles during deposition, and a method for manufacturing the same.

In order to solve the above problems, the sputtering target member according to an embodiment of the present invention is a sputtering target member formed of magnesium having a purity of 99.9% by mass or more, the sputtering target member having an average crystal grain size of magnesium of 42 µm or less.

In the sputtering target member according to the present embodiment, when measuring a sputtering surface by X-ray diffraction, the sputtering surface has an orientation rate of a (0001) plane of 50% or more.

In the sputtering target member according to the present embodiment, when measuring the sputtering surface by X-ray diffraction, the sputtering surface has the orientation rate of the (0001) plane of 80% or less.

The sputtering target member according to the present embodiment has an average strength of 65 MPa or more.

In the sputtering target member according to the present embodiment, the purity of magnesium is 99.95% by mass or more.

The sputtering target member according to the present embodiment has an oxygen content of 20 ppm by mass or less.

The sputtering target member according to the present embodiment has a carbon content of 80 ppm by mass or less.

The sputtering target member according to the present embodiment has a relative density of 99.0% or more.

Further, the method for manufacturing the sputtering target member according to the present embodiment is a method for manufacturing a sputtering target for manufacturing the above sputtering target member, the method comprising a rolling step of rolling a material at a material temperature of 100°C to 450°C to provide a rolled material.

In the method for manufacturing the sputtering target member according to the present embodiment, the rolling step comprises rolling the material at a rolling reduction ratio of more than 40% and 70% or less to provide the rolled material.

The method for manufacturing the sputtering target member according to the present embodiment further comprises, prior to the rolling step, a forging step of forging a magnesium casting material at a material temperature of 450°C or more by at least one of kneading forging and multiaxial forging to provide a forged material.

In the method for manufacturing the sputtering target member according to the present embodiment, the forging step comprises forging the casting material at the material temperature of 450°C to 550°C to provide the forged material.

In the method for manufacturing the sputtering target member according to the present embodiment, the forging step comprises removing wrinkles generated during forging of the casting material.

In the method for manufacturing the sputtering target member according to the present embodiment, the forging step comprises forging the casting material at a true strain of 2.0 to 6.0 to provide the forged material.

In the method for manufacturing the sputtering target member according to the present embodiment, the rolling step comprises rolling the material using a sheath.

According to the present embodiment, it is possible to provide a sputtering target member that efficiently decreases generation of particles during deposition.

### BRIEF DESCRIPTION OF THE DRAWINGS

FIG. 1 is a flowchart showing an outline of a method for manufacturing a sputtering target member according to an embodiment of the present invention;
FIG. 2 is a schematic view showing an example of multiaxial forging in a forging step of a method for manufacturing a sputtering target member according to an embodiment of the present invention;
FIG. 3 is a schematic view showing measured points of crystal grain sizes of sputtering target members obtained in Examples 1 to 6 and Comparative Examples 1 to 4;

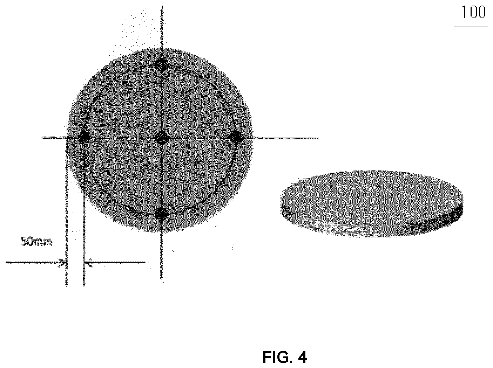

FIG. 4 is a schematic view showing measurement points of average flexural strength of sputtering target members obtained in Examples 1 to 6 and Comparative Examples 1 to 4; and
FIG. 5 is a schematic view showing measured positions of film thickness uniformity of a sputtered film relative to a target life in Examples 1 to 6 and Comparative Examples 1 to 4.

### DETAILED DESCRIPTION OF THE INVENTION

Hereinafter, the present invention is not limited to each embodiment, and elements can be modified and embodied without departing from the spirit of the invention. Further, various inventions can be formed by appropriately combining a plurality of elements disclosed in each embodiment. For example, some elements may be deleted from all elements shown in embodiments. Furthermore, elements of different embodiments may be combined as needed.

A sputtering target member formed of magnesium having a larger crystal grain size causes a problem that the number of particles during sputtering is increased, film thickness uniformity of a sputtered film is also deteriorated, and warpage is generated during sputtering. Further, the use of magnesium having higher purity as a raw material when manufacturing a sputtering target member results in difficulty to decrease the crystal grain size of magnesium forming the sputtering target member. Therefore, as a result of intensive studies, the present inventors have found that the particles can be effectively decreased during deposition if the sputtering target member are improved to be able to decrease the crystal grain size of high-purity magnesium, and the purity and average crystal grain size of magnesium of the sputtering target member are appropriately specified.

Hereinafter, the sputtering target member according to the present embodiment will be illustrated.

### [1. Sputtering Target Member]

According to a sputtering target member according to an embodiment of the present invention, particles can be efficiently decreased during deposition. The sputtering target member according to this embodiment is formed of magnesium having a purity of 99.9% by mass or more, and has an average crystal grain size of magnesium of 42 µm or less.

### (Purity)

In the sputtering target member according to the present embodiment, the purity of magnesium may be 99.9% by mass or more, and preferably 99.95% by mass or more, and more preferably 99.99% by mass or more, in terms of efficiently decreasing the generation of the particles. The purity of magnesium is a value excluding carbon, nitrogen, oxygen and hydrogen, and can be measured by GD-MS (Glow Discharge Mass Spectrometry). Measurement of impurities contained in the high-purity magnesium means results of analyzing, using Mg as a matrix, 73 components of impurity elements for Li, Be, B, F, Na, Al, Si, P, S, CI, K, Ca, Sc, Ti, V, Cr, Mn, Fe, Co, Ni, Cu, Zn, Ga, Ge, As, Se, Br, Rb, Sr, Y, Zr, Nb, Mo, Ru, Rh, Pd, Ag, Cd, In, Sn, Sb, Te, I, Cs, Ba, La, Ce, Pr, Nd, Sm, Eu, Gd, Tb, Dy, Ho, Er, Tm, Yb, Lu, Hf, Ta, W, Re, Os, Ir, Pt, Au, Hg, Tl, Pb, Bi, Th, and U.

### (Average Grain Size)

In the sputtering target member according to the embodiment, an average crystal grain size of magnesium is very low. The average crystal grain size of magnesium is 42 µm or less, and preferably 40 µm or less, and more preferably 35 µm or less, and further preferably 30 µm or less, in terms of efficiently decreasing the generation of the particles during deposition. That is, a lower average crystal grain size of magnesium is more preferable. In addition, typically, the average crystal grain size of magnesium is preferably 5 µm or more.

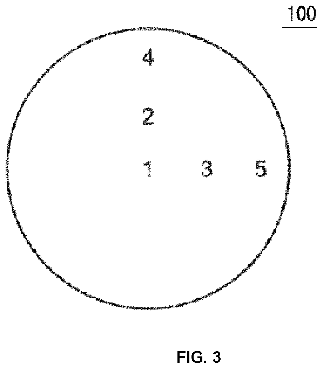

A method of measuring the average crystal grain size is now described with reference to FIG. 3. The crystal grain size is determined by measuring a crystal structure photograph taken in a specific visual field with an optical microscope using a commercially available data analysis software. The crystal grain size is calculated according to the average crystal grain area method of ASTM, so that the area of the crystal grain is converted into a circle, and a diameter of the circle is defined as the crystal grain size. Further, the crystal grain size is measured by sampling one point at a center of a sputtering target member 100 on a sputtering surface, two points at a position of R (diameter) x 1/2, and two points at a R position (outer peripheral portion). The symbol R indicates a radius of the sputtering target member 100. The average value of the measured crystal grain sizes is defined as the average crystal grain size.

### (Orientation Rate)

An increase in a ratio where a crystal plane parallel to the sputtering surface is (0001) (an orientation rate of a (0001) plane) results in uniform erosion of the entire sputtering surface, providing good uniformity of a thickness of a sputtered film. Also, the increased orientation rate of the (0001) plane suppresses warpage of the sputtering target member before and after the sputtering. Therefore, in the sputtering target member according to the present embodiment, the orientation rate of the (0001) plane is preferably 50% or more, and more preferably 55% or more, and still more preferably 60% or more, and still more preferably 70% or more. However, the orientation ratio of the (0001) plane is preferably 80% or less, and more preferably 75% or less, in terms of ensuring barrier properties of the formed thin film. The orientation rate of the (0001) plane is determined by calculating a ratio of integrated intensity of diffraction peaks of the (0001) plane to the total integrated intensity of the diffraction peaks detected by X-ray diffraction of the sputtering surface of the sputtering target member.

### (Average Strength)

The sputtering target member according to an embodiment of the present invention preferably has high strength in order to improve the uniformity of the film thickness and warpage of the sputtered film during deposition. For example, an average strength (an average tensile strength) is 65 MPa or more, and preferably 80 MPa or more, and more preferably 100 MPa or more. The average strength is an average value of tensile strengths measured at five or more points of the sputtering target member using a tensile compression tester according to "JIS Z 2241: 2011 Metallic materials-Tensile Testing-Method of test at room temperature".

### (Relative Density)

The sputtering target member according to an embodiment of the present invention preferably has a relative density of 99.0% or more. The relative density of the sputtering target member correlates with the quality of the sputtered film. If the sputtering target member has a lower density, the particles may be generated in the sputtered film due to abnormal discharge or dusts generated from holes. When the relative density is 99.0% or more, there are substantially no void in the interior, so that the generation of the particles due to the voids can be prevented. The relative density is calculated by the density of the sputtering target member obtained by the Archimedes method and the theoretical density of the composition (magnesium) in the sputtering target member.

### (Oxygen Content, Carbon content)

Oxides in the sputtering target material cause micro-arcing and generate the particles. Therefore, the sputtering target member preferably has an oxygen content of 20 ppm by mass or less, and more preferably 15 ppm by mass or less, and further preferably 10 ppm by mass or less, in terms of preventing excessive generation of the oxides. On the other hand, carbon in the sputtering target member produces carbon fine grains and compounds containing carbon, which will be starting points of cracking. Therefore, the sputtering target member preferably has a carbon content of 80 ppm by mass or less, and more preferably 70 ppm by mass or less, and further preferably 50 ppm by mass or less. The oxygen content and the carbon content in the sputtering target member are measured by an inert gas fusion-infrared absorption method.

### [2. Method for Manufacturing Sputtering Target Member]

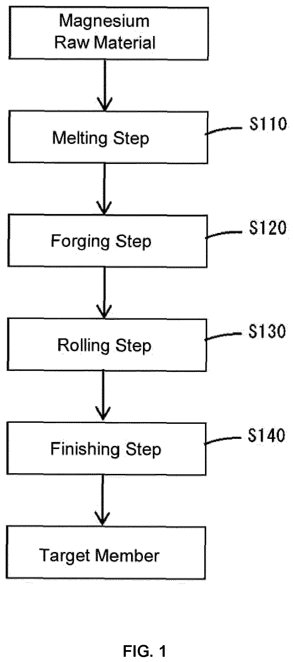

Next, a method for manufacturing the above sputtering target member will be illustrated with reference to the drawings. FIG. 1 is a flowchart showing an outline of a method for manufacturing the sputtering target member according to an embodiment of the present invention. The method for manufacturing the sputtering target member according to this embodiment includes: a melting step S110; a forging step S120; a rolling step S130; and a finishing step S140.

In order to efficiently decrease the particles during deposition, it is necessary to decrease the crystal grain size of magnesium forming the sputtering target member. Therefore, the present inventors have found that the average crystal grain size of magnesium forming the sputtering target member can be effectively decreased by carrying out rolling a material at a material temperature of 100 to 450°C to obtain a rolled material in the rolling step S130.

Hereinafter, each step in the method for manufacturing the sputtering target member according to the present embodiment will be described.

### <Melting Step>

In the melting step S110, for example, high-purity magnesium having a purity of 99.9% by mass or more is introduced into a carbon crucible and melted in a high vacuum atmosphere or an inert atmosphere. A temperature of the crucible is preferably from 700 to 1400°C, and more preferably from 700 to 900°C, and even more preferably from 700 to 800°C, in order to sufficiently carry out the melting reaction and prevent carbon from being contaminated from the carbon crucible. Further, a melting time is preferably from 10 to 60 minutes, and more preferably from 20 to 50 minutes, and even more preferably 30 to 40 minutes, in order to sufficiently carry out the melting reaction and prevent carbon from being contaminated from the carbon crucible.

The high-purity magnesium is thus melted to form a molten metal, and the molten metal is poured into a mold to obtain an ingot or billet (a casting material). For example, when the casting material is obtained, it is desirable that the molten metal is poured into the mold and the molten metal is rapidly cooled by a water-cooled mold or the like, which is equipped with a water cooling system, in order to refine the cast structure itself.

### (Heat Treatment)

After obtaining the casting material, a heat treatment may preferably be carried out at a temperature of 200 to 640°C to achieve a uniform structure.

### <Forging Step>

In the forging step S120, the casting material is forged by hot forging to obtain a forged material. For example, the casting material is forged at 450 to 550°C by at least one of kneading forging and multiaxial forging. By doing so, fine holes (pores) inherent in the casting material are previously reduced, so that the crystal grain size of magnesium forming the sputtering target member can be decreased without causing cracks or breakage in the rolling step S130 as described later.

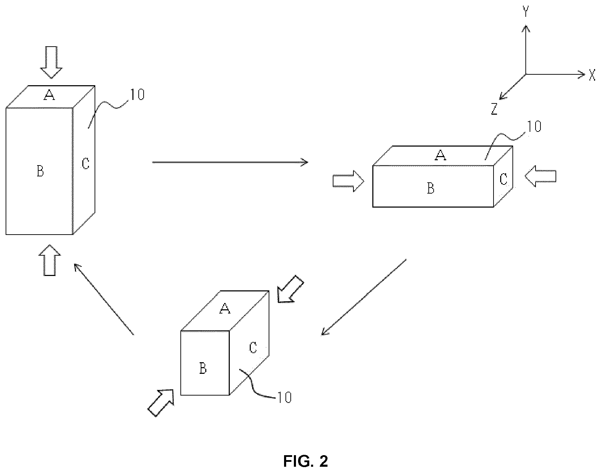

In the forging the casting material is plastically deformed and molded by applying a pressure. It is possible to aim at the decrease in the crystal grain size by large strain processing. The kneading forging is hot forging in which a large strain is alternately applied from a direction parallel to a height direction and a direction perpendicular to the height direction of a cylindrical casting material, thereby destroying the cast structure of the casting material. Specifically, when the strain is applied from the direction perpendicular to the height direction of the casting material, the pressure is applied from an outer diameter toward the center of the cylindrical casting material, and the casting material is processed such that the casting material extends in the height direction. On the other hand, when the strain is applied from the direction parallel to the height direction of the casting material, the casting material is processed such that the casting material shrinks in the height direction. In the multiaxial forging, the casting material 10 is subjected to compression processing from different directions, and the rectangular pillar shaped casting material 10 is sequentially subjected to the compression processing in three directions: X axis, Y axis, and Z axis, as shown in FIG. 2. This destroys the cast structure of the casting material 10.

In the forging step S120, the casting material is preferably forged by the kneading forging and then further forged by the multiaxial forging, in order to further decrease the crystal grain size of magnesium forming the sputtering target member. The order and number of the kneading forging processes and the multiaxial forging processes are not particularly limited.

During the forging of the casting material, wrinkles may be generated on the surface of the casting material. When the wrinkles remain in the obtained forged material, the wrinkles cause cracks in the sputtering target member. Therefore, in the forging step S120, the wrinkles generated during the forging of the casting material are preferably removed with a grinder.

### (Material Temperature)

The material temperature in the forging step S120 is 450°C or more, and preferably 470°C or more, and more preferably 490°C or more, in terms of decreasing the average crystal grain size of magnesium forming the sputtering target member and randomizing the crystal orientation to prevent cracking in the subsequent rolling step S130. However, in terms of suppressing cracking and breakage in the forged material, it is preferably 550°C or less, and more preferably 530°C or less, and even more preferably 510°C or less.

### (True Strain)

For example, in order to decrease the average crystal grain size of magnesium forming the sputtering target member, the forging is preferably carried out such that the true strain is from 2.0 to 6.0. Here, the true strain is calculated by In(a/b), in which In is natural logarithm, a is a height which is a longitudinal direction of the ingot before forging, and b is the height of the ingot after forging.

### (Heat Treatment)

After forging, a heat treatment may preferably be carried out at a temperature of 200 to 400°C to achieve a fine and uniform structure.

### <Rolling Step>

In the rolling step S130, the forged material is rolled by warm or hot rolling to obtain a rolled material. For example, the forged material is passed through a plurality of rolling rolls being rotated, and rolled at a material temperature of 100 to 450°C such that the rolling reduction rate is more than 40% and 70% or less.

### (Material Temperature)

A slip plane of the magnesium crystal is composed of three systems that are parallel to a bottom plane, a pillar plane, and a conical plane. A critical resolved shear stress of the slip of the conical plane is very larger than the critical resolved shear stress of the slip of the bottom or pillar plane and little slipping of the conical plane occurs at ordinarily temperature, because the crystal structure of magnesium is hexagonal. Therefore, at ordinarily temperature, the slipping in the conical plane direction in hexagonal crystal cannot be expected. Further, in magnesium produced by rolling at a relatively low temperature, a texture specific for magnesium is formed in which the bottom plane is arranged parallel to the rolling surface. When such a texture is formed, the bottom plane slipping and the conical plane slipping act in both a rolling direction (RD) and a plate width direction (TD), but do not act in a plate thickness direction (ND). If the parallel arrangement of the hexagonal crystal of magnesium excessively progresses, the rolled material of magnesium cannot be thinned in the plate thickness direction, so that the rolled material is broken during the process of rolling. The reason why the temperature at which the crystal orientation is randomized is preferable as the material temperature in the forging step S120 is to prevent the rolled material from being easily broken in the process of rolling because the hexagonal crystal of magnesium is already arranged parallel to the rolling surface at the start of the rolling step S130. Thus, at the relatively low rolling temperature, the forged material may crack during rolling. Therefore, the material temperature in the rolling step S130 is 100°C or more, and preferably 150°C or more, and more preferably 200°C or more, and even more preferably 250°C or more, in terms of suppressing excessive parallel arrangement of the magnesium hexagonal crystal to prevent cracking. However, from the viewpoint of suppressing the coarsening of the crystal grains and advancing the parallel arrangement of the magnesium hexagonal crystal to the extent that cracking does not occur, to increase the orientation rate of the (0001) plane of the rolled material, the material temperature is 450°C or less, and preferably 400°C or less, and more preferably 350°C or less, and still more preferably 300°C or less.

### (Rolling Reduction Ratio)

The rolling reduction ratio of the forged material is preferably more than 40%, and more preferably 45% or more, and still more preferably 50% or more, in terms of decreasing the particles during deposition. However, the rolling reduction ratio is preferably 70% or less, and more preferably 65% or less, and even more preferably 60% or less, in terms of suppressing cracking and breakage in the rolled material. Further, such a rolling reduction ratio can allow warpage of the sputtering target member before and after the sputtering to be suppressed to improve uniformity of the thickness of the sputtered film.

The arrangement of the rolling rolls is not particularly limited as long as it can be adjusted to a rolled material having a desired thickness or cross-sectional area, examples being a double rolling machine composed of two rolling rolls.

In the rolling step S130, the rolling is preferably carried out using a sheath, and for example, a ring made of aluminum (an Al ring) may be attached to an outer peripheral portion of the forged material and the rolling may be carried out. This can allow extension and strain of the outer peripheral portion of the forged material to be suppressed to prevent the outer peripheral portion from cracking.

### (Heat Treatment)

After rolling, a heat treatment may preferably be carried out at a temperature of 150 to 300°C to achieve a fine and uniform structure.

### <Finishing Step>

In the finishing step S140, the product obtained in the rolling step S130 can be machined or polished into a disc shape, a rectangular plate shape, a cylindrical shape, or the like, although not limited thereto.

### [3. Method for Manufacturing Sputtering Target]

A backing plate-integrated sputtering target can be manufactured by any known method from the sputtering target member manufactured by the above method for manufacturing the sputtering target member. An outer peripheral portion (which corresponds to a flange portion) of the sputtering target member is further forged by upsetting. This is then subjected to a heat treatment and then rapidly cooled to obtain a sputtering target material. The sputtering target material is then machined to produce a backing plate-integrated sputtering target (see, for example, WO 2015/037533 A1).

Further, the sputtering target may be manufactured by joining the sputtering target member to a backing plate. The sputtering target member and the backing plate may be joined together by any known method, for example, using low melting point solder or the like. Any known material may be used as the material of the backing plate, including copper (for example, oxygen-free copper), copper alloys, aluminum alloys, titanium, stainless steel, and the like.

A sputtering device that can be used in the sputtering target according to the present embodiment is not particularly limited. For example, a magnetron sputtering device, an RF application type magnetron DC sputtering device or the like can be used.

Then, using the sputtering target according to the embodiment, a MgO film is formed by the sputtering device. Such an MgO film can be applied to, for example, an MRAM to achieve a high barrier property.

### EXAMPLES

The present invention will be specifically described based on Examples and Comparative Examples. The following descriptions of Examples and Comparative Examples are merely specific examples for facilitating understanding of the technical content of the present invention, and the technical scope of the present invention is not limited by these specific examples. In the following descriptions, the purity of each magnesium raw material was measured by a GD-MS analyzer (product name VG-9000, from EVISA).

### (Example 1)

A magnesium raw material having a purity of 99.9% by mass was placed in a carbon crucible, and a temperature inside the crucible was raised to 900°C in a high vacuum atmosphere and maintained for 30 minutes to melt magnesium to obtain a molten metal. The molten metal was poured into a water-cooled copper mold to obtain an ingot (having an average crystal grain size of 5 mm). A surface layer of the obtained ingot was then removed to form a circular pillar shape to obtain an ingot having a diameter of 200 mm and a height of 100 mm. An average crystal grain size of the ingot was calculated in the same method as that of the crystal grain size of the sputtering target member as described later. In this case, the surface of the ingot was subjected to lathe processing (an arithmetic average surface roughness Ra ≤ 1.0 µm), followed by macro etching with nitric acid and observation.

The obtained ingot was rolled at a material temperature of 450°C at a roll delivery rate (15 m/min) to a rolling reduction ratio of 50% using a double rolling machine composed of two rolling rolls each having a diameter of 200 mm to obtain a rolled material having a height of 20 mm. The relative density of the rolled material was calculated as followed. The relative density is expressed as a percentage of a value obtained by calculating a measured density of the rolled material from an obtained volume and weight of the rolled material and dividing the measured density by the theoretical density of the rolled material.

A surface of the rolled material was then ground by machining to prepare a sputtering target member.

Physical properties of the sputtering target member were evaluated as follows:

### <Crystal Grain Size>

The crystal grain size was measured on a crystal structure photograph taken in a visual field of 1500 µm x 1200 µm with an optical microscope using an analysis SIS FIVE (Soft imaging System). The crystal grain size was calculated, according to the average crystal grain area method of ASTM (E.112-61), by converting an area of the crystal grain into a circle, and defining the diameter of the circle as the crystal grain size. As described above, the crystal grain size was measured at a total of five points as shown in FIG. 3.

### <Orientation Rate>

The sputtering target member was wet-polished with water-resistant abrasive paper to #2400 and dried to obtain a measurement sample. The X-ray diffraction was carried out under conditions: RINT-2200 from Rigaku Corporation; a tube: Cu; a tube voltage: 40 kV; a tube current: 40 mA; a scanning range (2θ): 20° to 100°; a slit size: divergence (DS) [mm]; scattering (SS) [mm]; a received light (RS) [mm]; a measurement step (2θ): 0.02°; and a scan speed: 4°/min. Then, the orientation rate (%) of the (0001) plane was calculated by the equation: {integrated intensity of (0001) plane detected by XRD method/total integrated intensity of peaks detected by XRD method} x 100.

### <Oxygen Content and Carbon Content of Inevitable Impurities>

For Mg forming the obtained sputtering target member, a concentration of O was measured by the inert gas melting-infrared absorption method (apparatus name: CS 6000 from LECO), and a concentration of C was measured by the inert gas melting-infrared absorption method (apparatus name: CS 844 from LECO).

### <Relative Density>

The density of the obtained sputtering target member was measured by the Archimedes method, and a percentage (%) relative to the theoretical density determined by the composition (Mg) of the sputtering target member was calculated, which was used as the relative density.

### <Average Strength>

The average strength was determined by using a tensile compression tester (AG-25 TA, from Shimadzu Corporation), processing five positions of the sputtering target member 100 processed to have a diameter of 15 mm and a length of a parallel portion of 50 mm to form metallic material tensile test pieces (JIS Z 2201), measuring tensile strengths of these test pieces, and calculating an average value of them. The tensile strength indicates a 0.2% proof stress value obtained from the stress-strain curve.

The sputtering target material was machined to produce a backing plate-integrated sputtering target having a diameter of 164 mm and a thickness of 14 mm. The sputtering was then carried out under the following conditions and evaluated.

### <Sputtering Conditions>

Device: product name C-7100, from Canon Anelva Co., Ltd.;
Power supply: DC method;
Electric power: 1000kW;
Degree of vacuum reached: 2 x 10⁻⁶ Pa;
Atmosphere gas: Ar;
Sputter gas pressure: 5.8 x 10⁻² Pa;
Sputter time: 120 seconds; and
Substrate: Si wafer.

### <Particles>

The number of particles adhering to the Si wafer substrate was measured with a surface foreign matter inspection device (SP5, from KLA-tencor). As a result, the particles having a size of 0.06 µm or more adhering to the substrate were counted.

### <Uniformity of Thickness of Sputtered Film>

The sputtering was carried out on one wafer every 1.5 kWh, and an average value of the film thicknesses at 49 points within each wafer surface was obtained by the X-ray reflectance method (XRR method). Using the average value, an average value between the wafers and a standard deviation were calculated to determine uniformity (%) of film thickness relative to a target life (uniformity (%) = (standard deviation between wafers/average value between wafers) x 100.

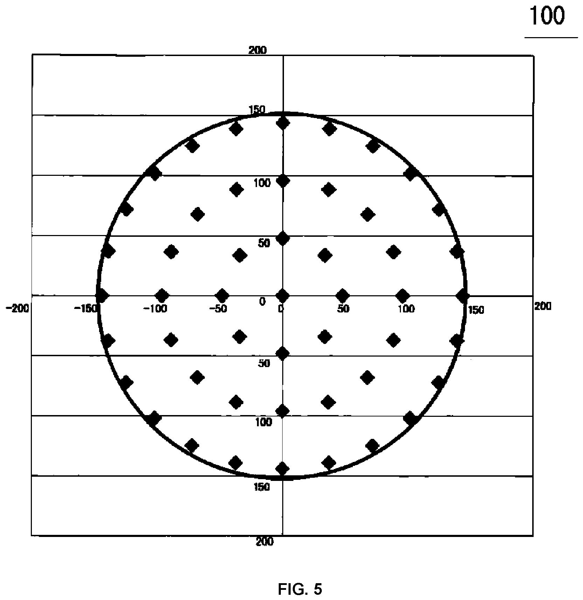

As shown in FIG. 5, the film thickness was determined by sampling one wafer center, eight R (diameter) x 1/3 points (45° intervals), and sixteen R (diameter) x 2/3 points (22.5° intervals), twenty-four R points (outer peripheral portions) (15° intervals), and measuring the total 49 points.

### <Warpage>

A straight edge (product name SEI-300, from UNI SEIKI) was applied to a back side of the sputtering surface of the sputtering target member before sputtering, warpage was measured for five members, and a warpage average value before use was calculated. Subsequently, when the sputtering target member was used to a target life of 100 kWh, the straight edge was applied to the back surface of the sputtering surface of the sputtering target member and warpage was measured for the five members, and the warpage average value after use was calculated. Then, a value obtained by subtracting the warp average value before use from the warp average value after use was defined as a warpage value.

The target life means the life of the target member from the start of use of the target until the target thickness is decreased by the progress of erosion due to the sputtering phenomenon to make the use of the target member impossible. This can be expressed by integration of the electric power during sputtering and the total sputtering time. In the present example, the life of the target member will be 100 kWh because the target member was used for 0.1 hour at an electric power of 1000 kW.

### (Example 2)

The same procedure as that of Example 1 was carried out, with the exception that when forging the obtained ingot, for the forging conditions, the ingot was subjected to three kneading forging processes and three multiaxial forging processes at a material temperature of 550°C such that the true strain was 6, and for the rolling conditions, the material temperature was changed to 100°C. In addition, wrinkles that were starting points of cracking in the sputtering target member were removed by a grinder every time the wrinkles occurred, during the forging.

Here, the true strain was calculated by In(a/b), in which a is a height which is a longitudinal direction of the ingot before forging, and b is the height of the ingot after forging.

### (Example 3)

The same procedure as that of Example 1 was carried out, with the exception that when forging the obtained ingot, for the forging conditions, the ingot was subjected to three kneading forging processes and three multiaxial forging processes at a material temperature of 550°C such that the true strain was 6, and for the rolling conditions, the material temperature was changed to 150°C. The wrinkles generated during forging were removed with a grinder.

### (Example 4)

The same procedure as that of Example 1 was carried out, with the exception that the purity of the magnesium raw material was changed to 99.95% by mass. The wrinkles generated during forging were removed with a grinder.

### (Example 5)

The same procedure as that of Example 1 was carried out, with the exception that when forging the obtained ingot, for the forging conditions, the ingot was subjected to three kneading forging processes and three multiaxial forging processes at a material temperature of 550°C such that the true strain was 2, and for the rolling conditions, the material temperature was changed to 450°C. The wrinkles generated during forging were removed with a grinder.

### (Example 6)

The same procedure as that of Example 1 was carried out, with the exception that when forging the obtained ingot, for the forging conditions, the ingot was subjected to three kneading forging processes and three multiaxial forging processes at a material temperature of 450°C such that the true strain was 2, and for the rolling conditions, the material temperature was changed to 450°C. The wrinkles generated during forging were removed with a grinder.

### (Comparative Example 1)

The same procedure as that of Example 1 was carried out, with the exception that the purity of the magnesium raw material was changed to 99.5% by mass.

### (Comparative Example 2)

The same procedure as that of Example 1 was carried out, with the exception that the magnesium raw material was changed to that having a carbon content of 100 ppm by mass and an oxygen content of 30 ppm by mass.

### (Comparative Example 3)

The same procedure as that of Example 1 was carried out, with the exception that for the rolling conditions, the material temperature was changed to 500°C.

### (Comparative Example 4)

The same procedure as that of Example 1 was carried out, with the exception that for the rolling conditions, the rolling reduction ratio was changed to 40%.

**Table 1**

| | Magnesium Raw Material | | | Average Grain Size of Ingot (mm) | Forging Conditions | | | | Rolling Conditions | | | Presence or Absence of Strain and Wrinkle Removal during Plastic Working |
|---|---|---|---|---|---|---|---|---|---|---|---|---|
| | Mg | C | O | | Forging Method | Number of Cycles | Temperature | True Strain | Temperature | Rolling Reduction Ratio | Relative Density | |
| | (% by mass) | (% by mass) | (% by mass) | | | | (°C) | | (°C) | (%) | (%) | |
| Example 1 | 99.9 | 80 | 20 | 5 | - | - | - | - | 450 | 50 | 99.9 | Present |
| Example 2 | 99.9 | 50 | 10 | 6 | Kneading→Multiaxial | 3 | 550 | 6 | 100 | 50 | 100 | Present |
| Example 3 | 99.9 | 60 | 10 | 5 | Kneading→Multiaxial | 3 | 550 | 6 | 150 | 50 | 100 | Present |
| Example 4 | 99.95 | 40 | 20 | 5 | - | - | - | - | 450 | 50 | 99.9 | Present |
| Example 5 | 99.9 | 50 | 20 | 4 | Kneading→Multiaxial | 3 | 550 | 2 | 450 | 50 | 100 | Present |
| Example 6 | 99.9 | 70 | 20 | 5 | Kneading→Multiaxial | 3 | 450 | 2 | 450 | 50 | 100 | Present |
| Comparative Example 1 | 99.5 | 80 | 20 | 5 | - | - | - | - | 450 | 50 | 99.9 | Present |
| Comparative Example 2 | 99.9 | 100 | 30 | 5 | - | - | - | - | 450 | 50 | 99.9 | Present |
| Comparative Example 3 | 99.9 | 60 | 20 | 5 | - | - | - | - | 500 | 50 | 99.9 | Present |
| Comparative Example 4 | 99.9 | 70 | 10 | 6 | - | - | - | - | 450 | 40 | 99.9 | Present |

**Table 2**

| | Physical Properties of Sputtering Target Member | | | | | | Sputtering Characteristics | | |
|---|---|---|---|---|---|---|---|---|---|
| | C (ppm by mass) | O (ppm by mass) | Average Grain Size (µm) | Orientation Rate (%) | Average Strength (Mpa) | Relative Density (%) | Number of Particles | Uniformity (%) | Warpage (mm) |
| Example 1 | 80 | 20 | 42 | 51 | 70 | 99.9 | 68 | <2 | 0.3 |
| Example 2 | 50 | 10 | 8 | 72 | 136 | 100 | 25 | 0.6 | 0.1 |
| Example 3 | 60 | 10 | 17 | 70 | 103 | 100 | 37 | 0.8 | 0.1 |
| Example 4 | 40 | 20 | 37 | 55 | 69 | 99.9 | 54 | <2 | 0.3 |
| Example 5 | 50 | 20 | 39 | 53 | 74 | 100 | 49 | <2 | 0.2 |
| Example 6 | 70 | 20 | 35 | 56 | 81 | 100 | 42 | <2 | 0.2 |
| Comparative Example 1 | 80 | 20 | 44 | 52 | 85 | 99.9 | 121 | - | - |
| Comparative Example 2 | 100 | 30 | 46 | 50 | 74 | 99.9 | 139 | - | - |
| Comparative Example 3 | 60 | 20 | 53 | 51 | 63 | 99.9 | 110 | >2 | 0.6 |
| Comparative Example 4 | 70 | 10 | 43 | 44 | 59 | 99.9 | 106 | >2 | 0.5 |

### (Discussion of Examples)

In Examples 1 to 6, it is understood from Table 2 that the average crystal grain size of the sputtering target member formed of the magnesium raw material having the purity of 99.9% by mass or more was 42 µm or less, thereby effectively decreasing the particles during deposition.

Moreover, in Examples 2 and 3, the crystal orientation was randomized by forging at the temperature of 450°C or more, so that the forged material could be rolled at the temperature of 400°C or less without causing cracks in the rolled material. As a result, in each of the sputtering target members of Example 2 and Example 3, the average crystal grain size was 30 µm or less, and the number of particles was further decreased. Further, as a result of rolling the sputtering target members of Examples 2 and 3 at the temperature of 400°C or less, the orientation rate of the (0001) plane was 70% or more, and the average strength was 100 MPa or more. Therefore, in each of the sputtering target members of Example 2 and Example 3, the uniformity of the thickness of the sputtered film was further improved, and the warpage of the sputtering target member before and after sputtering was further suppressed.

### Description of Reference Numerals

10 casting material
100 sputtering target member
S110 melting step
S120 forging step
S130 rolling step
S140 finishing step

## Claims

1. A sputtering target member formed of magnesium having a purity of 99.9% by mass or more, the sputtering target member having an average crystal grain size of magnesium of 42 µm or less.

2. The sputtering target member according to claim 1, wherein, when measuring a sputtering surface by X-ray diffraction, the sputtering surface has an orientation rate of a (0001) plane of 50% or more.

3. The sputtering target member according to claim 2, wherein, when measuring the sputtering surface by X-ray diffraction, the sputtering surface has the orientation rate of the (0001) plane of 80% or less.

4. The sputtering target member according to any one of claims 1 to 3, wherein the sputtering target member has an average strength of 65 MPa or more.

5. The sputtering target member according to any one of claims 1 to 4, wherein the purity of magnesium is 99.95% by mass or more.

6. The sputtering target member according to any one of claims 1 to 5, wherein the sputtering target member has an oxygen content of 20 ppm by mass or less.

7. The sputtering target member according to any one of claims 1 to 6, wherein the sputtering target member has a carbon content of 80 ppm by mass or less.

8. The sputtering target member according to any one of claims 1 to 7, wherein the sputtering target member has a relative density of 99.0% or more.

9. A method for manufacturing a sputtering target member according to any one of claims 1 to 8, the method comprising:
a rolling step of rolling a material at a material temperature of 100°C to 450°C to provide a rolled material.

10. The method according to claim 9, wherein the rolling step comprises rolling the material at a rolling reduction ratio of more than 40% and 70% or less to provide the rolled material.

11. The method according to claim 9 or 10, further comprising, prior to the rolling step, a forging step of forging a magnesium casting material at a material temperature of 450°C or more by at least one of kneading forging and multiaxial forging to provide a forged material.

12. The method according to claim 11, wherein the forging step comprises forging the casting material at the material temperature of 450°C to 550°C to provide the forged material.

13. The method according to claim 11 or 12, wherein the forging step comprises removing wrinkles generated during forging of the casting material.

14. The method according to any one of claims 11 to 13, wherein the forging step comprises forging the casting material at a true strain of 2.0 to 6.0 to provide the forged material.

15. The method according to any one of claims 9 to 14, wherein the rolling step comprises rolling the material using a sheath.
